# EUROPEAN PATENT APPLICATION

(11) **EP 3 133 188 A1**
(43) Date of publication of application: **22.02.2017**
(21) Application number: 14889691.3
(22) Date of filing: 15.04.2014
(51) Int. Cl.: C23C 26/00, B05D 7/24, F21S 2/00, H01L 33/62

(54) **COATING FILM, METHOD FOR FORMING COATING FILM, AND LIGHT-EMITTING DIODE DEVICE**

(71) Applicant: Sumitomo Metal Mining Co., Ltd., Tokyo 105-8716 (JP)
(72) Inventor: YAMABE, Hidetoshi, Ichikawa-shi Chiba 272-8588 (JP); NAGAO, Harumi, Ichikawa-shi Chiba 272-8588 (JP); OOTA, Yousuke, Ichikawa-shi Chiba 272-8588 (JP)
(74) Representative: Klingseisen, Franz
(86) International application number: PCT/JP2014/060748
(87) International publication number: WO 2015/159371

(57) **Abstract**

A coating film is formed on the surface of a metal material, wherein the coating film is capable of preventing discoloration due to corrosion of the surface of the metal material even during heat treatment at the time of manufacturing or when used in an outdoor environment over a long period of time, and has an excellent bonding characteristic.

A 4 nm to 14 nm thick polysiloxane film, which includes a polysiloxane of which the principal chain is -(Si-O-Si)ₙ- and that is formed by mixing and spraying a hexamethyldisiloxane compound together with nitrogen gas as a carrier gas at atmospheric pressure in a nitrogen plasma gas, and then performing polymerization by radicalizing that hexamethyldisiloxane compound, is formed on the surface of a metal material.

## Description

### TECHNICAL FIELD

The present invention relates to a coating film that is formed on the surface of a metal material, particularly silver or silver alloy, to a method for forming that coating film, and to a light-emitting diode device that includes that coating film.

### BACKGROUND ART

Material that is formed by performing copper or nickel under plating, and then silver plating on top of that on the surface of a metal alloy such as brass, phosphor bronze is often used for connectors or lead frames that are connecting parts for electronic devices. Silver is a good conductor of electricity and heat, so is often used as a plating material for connectors or lead frames. However, there is a problem in that silver discolors easily in air, and particularly undergoes corrosion and discolors to a dark reddish-brown color or to a bluish black color in an atmosphere that includes sulfur, and electrical contact becomes bad.

Incidentally, in recent years, from the aspect of saving energy and protecting the environment, the use of white light-emitting diode devices as new light sources and lighting equipment to replace incandescent light bulbs and fluorescent lights that have been used up until now has gained attention. Light-emitting diode (LED) devices are designed so that by processing the pedestal of a lead frame and placing an LED chip in a position that is surrounded by a reflecting section, light that is emitted from the LED chip can be effectively obtained from the reflecting section. The LED chip, as necessary, is sealed in an epoxy resin or the like.

Metal film such as silver, aluminum, gold and the like is used as a reflective material that is used in the reflecting section of this kind of LED device. Particularly, silver has a high degree of glossiness and reflectivity and is the most suitable material as a reflective material. However, as described above, silver discolors easily in air, and this kind of discoloration causes a decrease in the performance of a silver coating as a reflective material. Particularly, in an LED device, there is a problem in that the reflective performance of a silver coating decreases due to discoloration during heat treatment during production, or when used in a high-temperature environment.

In order to avoid these problems, surface treatment is performed on the metal film. More specifically, by treating the surface of these metal films with a specified processing liquid, the corrosion resistance and heat resistance of the metal film is improved, and discoloration of the metal film is prevented.

For example, JPH05311492 (A) discloses a method of processing silver plating in a solution that includes an inhibitor (corrosion inhibitor). Moreover, JPH09249977 (A) discloses a method of applying a surface treatment liquid, which includes a lubricant and an emulsifying agent in a specific inhibitor such as benzotriasole, on the surface of silver plating material. In these methods, a certain effect of preventing discoloration due to corrosion of silver plating is recognized, however, that prevention is not sufficient, and depending on the operating environment, it is not possible to avoid the occurrence of partial discoloration.

On the other hand, JP2004169157 (A) discloses a method for processing a silver plating layer with an organic compound having reactivity or affinity with silver such as an organic compound or nitrogen-containing heterocyclic compound having a thione group or mercapto group for the purpose of improving the strength and corrosion resistance of the silver plating layer. However, in this literature, the corrosion resistance of the silver plating layer was only evaluated according to pealing or cloudiness of the silver plating layer when sprayed with an aqueous solution formed by adding a small amount of acetic acid and cupric chloride to 5% by mass saline solution. Therefore, it is unclear whether or not the processed silver plating layer has sufficient corrosion resistance and heat resistance, and whether or not discoloration as described above can be prevented when the processed silver plating layer is heat treated or when used in a high-temperature environment or in an atmosphere that includes sulfur.

In addition, JP2011202239 (A) discloses a surface treatment agent that includes a specific inhibitor such as benzotriazole and the like, and iodide and/or bromide, and that has been adjusted to a pH of 4 to 7. Furthermore, JP2011241409 (A) discloses a surface treatment method of performing direct-current electrolysis under specified conditions in a surface treatment agent aqueous solution that includes a specific inhibitor such as benzotriazole and the like and that has been adjusted to a pH of 4 to 7, with a metal material that has been plated with silver or silver alloy plating as an anode. According to the literature above, coating films having improved heat resistance are obtained by the surface treatment agent or the surface treatment method described above. However, for the coating films that are formed using these surface treatment agents or surface treatment methods, coloration of the films themselves cannot be avoided, and the coating films do not have sufficient compactness or sulfur resistance, so cannot be said to be able to tolerate practical use.

In this way, conventional surface treatment agents or surface treatment methods have a problem in that either the compactness, sulfur resistance or heat resistance of the obtained coating film is inferior. Therefore, even in the case that these surface treatment agents or surface treatment methods are applied to the surface treatment of a metal film of the reflecting section of an LED device or the like, a problem occurs in that when there is permeation of corrosive gas during manufacturing or use of the product, the color fastness of the coating film decreases, which causes the light reflecting performance of the metal film to decrease. Moreover, these are wet type surface treatment processes, so it is difficult to evenly form a thin coating film having a thickness of 100 nm or less everywhere. Furthermore, the reflecting section of an LED device is a kind of connecting part of a lead frame, and wire bonding is used in the connection with the LED chip, however, when the thickness of the coating film is too thick, or the wettability becomes bad, there is a possibility that problems will occur in the wire bonding characteristic and that the connection will be insufficient.

On the other hand, JP2010058111 (A) discloses a dry type surface treatment process that is related to forming a reflecting surface of a reflector in an automobile lamp, and layers an undercoat layer, a reflecting layer that is a silver deposition film, and a topcoat layer on a substrate using a plasma CVD method. In this method, a silicon oxide film (SiOₓ) that is formed by plasma polymerization using a silane compound such as hexamethyldisiloxane (HMDSO) is used for the undercoat layer and the topcoat layer. With this dry type surface treatment process, it is possible to form a metal film and coating film in a short amount of time compared to a wet type surface treatment process, and it is possible to obtain a coating structure that does not have a decrease in the light reflecting performance. Moreover, film formation material is not scattered and dispersed inside the factory, so it is possible to maintain a good working environment. However, surface treatment using a plasma CVD method is typically expensive, and large vacuum equipment or pressure reduction equipment is necessary, so there is a problem in that this invites increased production costs and worsened productivity.

JP2004510571 (A) discloses a method of forming a coating that includes polydimethylsiloxane on the surface of a substrate made of metal or the like by introducing a spray coating formation material that includes an organic silicon compound such as dimethylsiloxane into an atmospheric pressure plasma discharge, and exposing the substrate to the spray coating material. According to this literature, by forming this kind of coating, it is possible to give corrosion resistance and oxidation resistance to the substrate. This literature discloses that a siloxane derived coating can oxidize by plasma treatment that includes oxygen, and that by performing plasma treatment in non-oxidizing conditions, it is possible to form a siloxane polymer. However, the thickness of the coating that is formed with this technology becomes approximately 300 nm, so applying this technology to a coating film of a reflecting section of an LED device has a problem from the aspect of wire bonding characteristic. Moreover, with this technology, gas plasmatization and activation of spray coating formation material that is to be atomized are performed simultaneously, so activation of the spray coating formation material becomes non-uniform, and it is difficult to evenly form a compact coating everywhere over the substrate surface. Particularly, when there is a passive film on the surface of the metal material that is to be coated, or when using a noble metal as the metal material, the states of these surfaces are inactive and have low-energy, so it is very difficult to evenly form a coating film using an organic material everywhere over the surface. Therefore, with this technology, even in the case in which a very thin coating film can be formed on the surface of a metal film such as silver, there is a possibility that a problem of generating a bad external appearance such as processing irregularities or stains will occur.

### [Related Literature]

### [Patent Literature]

[Patent Literature 1] JPH05311492 (A)
[Patent Literature 2] JPH09249977 (A)
[Patent Literature 3] JP2004169157 (A)
[Patent Literature 4] JP2011202239 (A)
[Patent Literature 5] JP2011241409 (A)
[Patent Literature 6] JP2010058111 (A)
[Patent Literature] 7] JP2004510571 (A)

### SUMMARY OF INVENTION

### [Problems to be Solved by Invention]

The object of the present invention is to provide a coating film that is capable of preventing discoloration of a metal material of a reflecting section of an LED device, and particularly discoloration due to corrosion of the surface of silver plating even during heat treatment during manufacture of the LED device or when used in an outdoor environment over a long period of time, and that has an excellent wire bonding characteristic; and to provide a method for forming this coating film on the surface of a metal material.

### [Means for Solving Problems]

The coating film of the present invention is a coating film that is formed on the surface of a metal material and includes a 4 nm to 14 nm thick polysiloxane film that is formed by mixing and spraying an organic silicon compound having a siloxane bond together with a carrier gas that includes at least nitrogen at atmospheric pressure in a nitrogen plasma gas, and performing polymerization by radicalizing that organic silicon compound.

Preferably, the polysiloxane film includes a polysiloxane of which the principal chain is - (Si - O - Si)ₙ -, and more preferably includes a polysiloxane to which an alkyl group is mainly bonded in a side chain (general formula: R₃SiO - (R₂SiO)ₙ - SiR₃) (where R is an arbitrary alkyl group), and even more preferably includes a dimethylpolysiloxane of which R in the general formula is a methyl group.

The coating film of the present invention is suitably applied to a light-emitting diode (LED) device. In other words, the LED device of the present invention includes a lead frame, a reflecting section that is obtained by processing the pedestal of that lead frame, and an LED chip that is placed in a position that is surrounded by the reflecting section, wherein the reflecting section includes a metal film and the coating film of the present invention that is formed on the surface of that metal film. The present invention is suitably applied in case that the metal film is silver film or silver alloy film.

Preferably, when the reflecting section of the metal film includes a silver film or a silver alloy film and the coating film that is formed on that film, the brightness L value of the reflecting section is 80 or more, and more preferably 84 or more.

On the other hand, the method for forming a coating film of the present invention is characterized by forming on the surface of a metal material a 4 nm to 14 nm thick polysiloxane film that is obtained by mixing and spraying an organic silicon compound having a siloxane bond together with a carrier gas that includes at least nitrogen at atmospheric pressure in a nitrogen plasma gas, and performing polymerization by radicalizing that organic silicon compound.

In the present invention, preferably at least one kind selected from hexamethyldisiloxane (HMDSO), octamethyltrisiloxane (OMTSO), decamethyltetrasiloxane (DMTSO), and octamethylcyclotetrasiloxane (OMCTSO) is used as the organic silicone compound. Particularly, using hexamethyldisiloxane is even more preferred.

Preferably, formation of the coating film is performed using an atmospheric pressure plasma polymerization device, with the distance from the supply nozzle of the device to the surface of the metal material being 5 mm to 30 mm, and the movement speed of the supply nozzle being 10 m/min to 40 m/min.

Preferably, the polysiloxane film includes a polysiloxane of which the principal chain is - (Si - O - Si)ₙ -, and more preferably includes a polysiloxane to which an alkyl group is mainly bonded in a side chain (general formula: R₃SiO - (R₂SiO)ₙ - SiR₃) (where R is an arbitrary alkyl group), and even more preferably includes a dimethylpolysiloxane of which R in the general formula is a methyl group.

The present invention is suitably applied when the metal material is silver or a silver alloy.

### [Effect of Invention]

With the present invention, it is possible to evenly form a transparent and very thin compact coating film everywhere over the entire surface of a metal material in a short time. Therefore, there is hardly any occurrence of a bad external appearance caused by processing irregularities or stains due to surface treatment. Moreover, the coating film that is obtained according to the present invention has excellent sulfur resistance and oxidation resistance, so the effect of preventing discoloration due to corrosion is high, and there is hardly any problem with degradation of the light reflecting performance. The coating film of the present invention also has high bonding strength with a bonding wire, and the wire bonding characteristic is excellent.

Furthermore, with the present invention, a vacuum device or pressure reduction device is not used, and the polymerization reaction of an organic silicon compound having a siloxane bond can proceed efficiently under atmospheric pressure, so equipment can be simplified and it is possible to improve production and reduce production cost.

The coating material that is used in the atmospheric pressure plasma polymerization process of the present invention is a liquid-state organic silicon compound that is a liquid at normal temperature and does not includes an organic solvent or heavy metal, so handling is easy and safety is excellent.

### BRIEF EXPLANATION OF DRAWINGS

### FIG. 1 is a cross-sectional view of an example of an LED device to which the coating film of the present invention has been applied.

### MODES FOR CARRYING OUT INVENTION

An example of an embodiment of the present invention will be explained in detail below by dividing the explanation into an explanation of the coating film, the method for forming the coating film, and an LED device to which the coating film is applied.

### 1. Coating Film

The coating film of the present invention is a coating film that is formed on the surface of a metal material, and is a polysiloxane film having a thickness of 4 nm to 14nm that is formed by mixing and spraying an organic silicon compound having a siloxane bond together with a carrier gas that includes at least nitrogen in nitrogen plasma gas at atmospheric pressure, and performing atmospheric pressure plasma polymerization by radicalizing this organic silicon compound.

The material on which the coating film of the present invention is formed is not particularly limited as long as the material is a metal material, and the present invention can be applied to an arbitrary metal material. However, the present invention is particularly suitable for use with a silver or silver alloy material that discolors easily in an outdoor environment.

The coating film of the present invention can also be applied to connectors or lead frames, which are connecting parts for normal electronic devices and for which worsening of electrical connection due to corrosion becomes a problem. Particularly, the coating film of the present invention is suitable for the reflecting section of a light-emitting diode (LED) device for which degradation of the light reflecting performance due to discoloration caused by sulfuration or oxidation, or discoloration due to heat treatment during manufacturing or use in a high-temperature environment becomes a problem.

### (Polysiloxane Film)

The kind of polysiloxane of the polysiloxane film of the present invention is arbitrary, however, when taking into consideration the effect of the invention, or in other words the transparency (no color) as a transflective film, or the compactness as a film, preferably the polysiloxane is a polysiloxane having - (Si - O - Si)ₙ - (siloxane bond) as the principal chain. As this kind of polysiloxane, it is possible to use a polysiloxane that is expressed by the general formula: R₃SiO - (R₃SiO)ₙ - SiR₃ (where R is an arbitrary alkyl group), or a polysiloxane having a structure in which part of the side chain of R in the general formula above is replaced with a phenyl group (- C₆H₅), or a polysiloxane having a structure in which part of the side chain of R in the general formula above is replaced with an organic group, and carbon is combined with part. The organic group in the present invention means a functional group that includes at least one carbon, for example, it is possible to use an amino group (- RNH₂), a carboxyl group (-RCOOH), a carbinol group (- ROH), a polyether group and the like.

Of these, from the aspect of obtaining a coating film having high flexibility, a polysiloxane that is expressed by the general formula above is more preferred, and from the aspect of obtaining a more compact coating film, a polysiloxane of which R is a methyl group (structural formula: (CH₃)₃SiO - [(CH₃)₂SiO]ₙ - Si(CH₃)₃) is further preferred.

### (Film Thickness)

The thickness of the coating film (polysiloxane film) of the present invention is in the range 4 mn to 14 nm, and preferably in the range 6 nm to 12 nm. When the thickness of the coating film is less than 4 nm, it is not possible to obtain corrosion resistance, and particularly sufficient sulfur resistance, so it is not possible to sufficiently obtain the effect of preventing discoloration due to corrosion. Moreover, when forming the coating film of the present invention on the metal film, it is not possible to sufficiently obtain the effect of improving brightness. On the other hand, when the thickness is greater than 14 nm, the thickness is sufficient for corrosion resistance, however, not only does yellow coloration become noticeable and the brightness and external appearance become bad, the wire bonding characteristic worsens. In addition, the insulation property becomes too high, and there is also a problem in that the contact resistance increases.

As described above, even though the coating film of the present invention is a very thin film, the coating film becomes a compact protective film that is evenly formed everywhere over the entire surface of the metal material. Therefore, it is possible to protect the metal material that exists inside. As a result, it is possible to greatly improve the corrosion resistance (sulfur resistance and oxidation resistance) of the metal material, and particularly the resistance to discoloration (color fastness) due to corrosion caused by sulfur when compared with using a conventional surface treatment agent that includes an inhibitor. Moreover, the coating film of the present invention is such that a compact film is evenly formed everywhere over the entire surface, so it is possible for the coating film to have a remarkable characteristic of not having a bad external appearance due to processing irregularities or stains due to surface treatment even when compared with the case in which it is presumed to be possible to apply the technology that is disclosed in JP2004510571 (A) to the formation of a very thin coating film having a thickness of about 4 nm to 14 nm.

Moreover, the metal material on which the coating film of the present invention is formed can be a material having an excellent wire bonding characteristic, which means the bonding strength with a bonding wire. The wire bonding characteristic is normally evaluated by using a specified bond tester, clamping a bonding wire that is bonded to a sample (opposing surface), pulling 90°, cutting a 2nd bonding section, and determining whether the fracture position is a wire section or a bonded interface. In other words, when the fracture position is a wire section, the wire bonding characteristic is evaluated as being high (the bonding strength is sufficiently high), and when the fracture position is a bonded interface, the wire bonding characteristic is evaluated as being low (bonding strength is insufficient).

Furthermore, by forming the coating film of the present invention on the surface of a metal material with a suitable film thickness, it is possible to greatly improve an L value that indicates the brightness of the coating film. For example, by coating a metal film that includes silver or a silver alloy (brightness L value: 70 to 75) using the coating film of the present invention (polysiloxane film) having a thickness that is within the film thickness specified by present invention, it is possible to make the brightness L value of the coating film 80 or greater, and preferably 84 or greater. Here, the brightness L value is a value of the brightness L* when color is illustrated using a L*a*b* color system (JIS Z8729) where the brightness axis is taken to be L*, the axis for red to green shades is taken to be a* and the axis for yellow to blue shades is taken to be b*. The brightness L value can be found by using a spectrophotometric colorimeter by taking the brightness L value of black to be 0, and the brightness L value of white to be 100.

In addition, the coating film of the present invention is formed to be very strong, so has a feature of being highly stable and having very little degradation over time. Therefore, even when the metal material on which this coating film is formed is exposed to an outdoor environment over a long period of time, it is possible to maintain the features above in a high state.

### 2. Method for Forming Coating Film

Next, the method for forming the coating film of the present invention will be explained. The polysiloxane film of the coating film of the present invention can only be formed by an atmospheric plasma polymerization process under restricted conditions, or in other words, can only be formed by the method for forming coating film of the present invention.

Plasma processing is a widely known conventional technology, however, the atmospheric pressure plasma polymerization process of the present invention takes advantage of the characteristic of causing a chemical reaction that normally does not advance to advance by activation of reacting particles by atmospheric pressure plasma. Atmospheric pressure plasma is suited for continuous processing so productivity is high, and because vacuum equipment is not necessary, processing cost is low and can be performed using simple apparatus construction. The atmospheric pressure plasma of the present invention can be generated using an arbitrary method such as corona discharge, dielectric barrier discharge, RF discharge, microwave discharge, arc discharge and the like.

### (Plasma Gas and Carrier Gas)

In conventional plasma processing, inert gases argon (Ar) and helium (He) are typically used as a plasma gas (ionizing gas) and carrier gas. However, in the atmospheric pressure plasma polymerization process of the present invention, there is no need to use these expensive inert gases and it is possible to use gases that include at least nitrogen as the plasma gas and carrier gas. In other words, it is possible to use a gas mixture of nitrogen and oxygen that include normal air. This kind of gas mixture is inexpensive and easy to handle, so not only is it possible to improve productivity, it is also possible to improve workability.

In order to generate nitrogen plasma, the amount of nitrogen included in the plasma gas and carrier gas is preferably in the range of 30% by volume to 100% by volume. By making the amount of nitrogen included 30% by mass or more, oxidation of organic silicon compound having a siloxane bond, which is the coating material, is prevented, and it becomes possible to perform radicalization while maintaining the basic structure as is.

However, even when the amount of nitrogen included is 30% by volume or greater, depending on the processing conditions, there are cases in which the oxygen or air will become hot during the plasmatization process, and the organic silicon compound having a siloxane bond, which is the coating material, will undergo oxidative decomposition and the obtained coating film becomes silicon oxide (SiOₓ) film. In such a case, it is possible to suppress oxidative decomposition of the organic silicon compound by increasing the amount of nitrogen included in the plasma gas and carrier gas to preferably be 40% by volume to 100% by volume, and more preferably 100% by volume.

The device used for plasmatizing a gas that includes at least nitrogen, and preferably nitrogen gas is not particularly limited as long as it is possible to perform plasmatization under atmospheric pressure, and it is possible to use a known plasma generating device. Here, atmospheric pressure in the present invention includes atmospheric pressure (1013.25 hPa) and air pressure near atmospheric pressure; and air pressure that is within the normal range of change in atmospheric pressure is also included.

### (Plasmatization Conditions)

The condition for plasmatizing plasma gas (nitrogen gas or the like) should be appropriately selected according the performance of the device used and the target film thickness, however, from the aspect of forming a high-quality coating film by efficiently radicalizing an organic silicon compound that has a siloxane bond, which is used as the coating material, the generator output voltage is preferably in the range 150V to 350V, and more preferably is in the range 200V to 330V. When the generator output voltage is less than 150V, it is not be possible to sufficiently plasmatize the nitrogen gas, and thus it may not be possible to sufficiently radicalize the organic silicon compound. Moreover, when the generator output voltage is greater than 350V, there is a possibility that the device will become damaged.

### (Coating Material)

As the coating material in the present invention, it is possible to use an organic silicon compound that has a siloxane bond and which is normally a liquid. By using this kind of organic silicon compound, it is possible to form a coating film that includes a polysiloxane that is expressed by the general formula: R₃SiO - (R₂SiO)ₙ - SiR₃ (where R is an arbitrary alkyl group).

As the organic silicon compound having a siloxane bond, it is possible to use at least one kind of organic silicon compound that is selected from among hexamethyldisiloxane (HMDSO), octamethyl trisiloxane (OMTSO), decamethyl tetrasiloxane (DMTSO), which are linear siloxanes, and octamethylcyclotetrasiloxane (OMCTSO), which is a cyclic siloxane. Even of these coating materials, hexamethyldisiloxane (HMDSO) that is expressed by the following chemical formula (chemical formula 1) has characteristics of having a boiling point of 99.5°C, is a colorless and odorless liquid, and is stable in air, so from the aspect of being easy to handle, is preferably used.

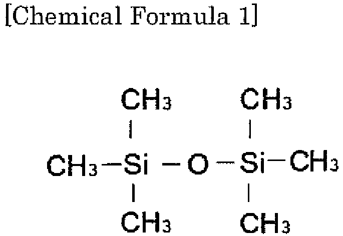

When forming the coating film of the present invention using an organic silicon compound having these siloxane bonds, it is possible to form a coating film using dimethylpolysiloxane (structural formula: (CH₃)₃SiO - [(CH₃)₂SiO]ₙ - Si(CH₃)₃).

Moreover, as described above, when the coating film of the present invention is formed using polysiloxane having a structure in which of R in the general formula: R₃SiO - (R₂SiO)ₙ - SiR₃ (where R is an arbitrary alkyl group) part of the side chain is replaced with a phenyl group, or when a using a polysiloxane having a structure in which of R part of the side chain is replaced with an organic group and the carbon is combined, a material of which part of the side chain of the organic silicon compound above is replaced beforehand with a phenyl group or organic group can be used as the coating material. Alternatively a mixture of the organic silicon compound above and other compounds having a phenyl group or organic group can be used as the coating material.

The method for spraying the coating material mixture in a nitrogen plasma gas is not particularly limited as long as the coating material is sprayed and mixed in nitrogen gas that has already been plasmatized in atmospheric air (nitrogen plasma gas), and it is possible to use known equipment or a known method.

When the coating material that is introduced inside the nitrogen plasma gas in this way comes in contact with the nitrogen plasma gas, a reaction advances in which radicals are generated. As a result, radicals, which are generated while maintaining the basic structure of the organic silicon compound that has a siloxane bond, react with the metal that exists on the surface of the metal material, and by performing polymerization after becoming fixed, a coating film that includes polysiloxane is formed instantly. Therefore, the formation method for forming the coating film of the present invention differs from a conventional process for plasmatizing a gas mixture as disclosed in JP2004510571 (A) in that even when there is a passive film on the surface of a metal material, or even when the metal material includes a noble metal, it is possible to evenly form a compact coating film everywhere over the surface.

### (Nozzle Distance, Nozzle Movement Speed)

In the present invention, as described above, the thickness of the coating film is regulated to the range 4 nm to 14 nm, however, the thickness of the coating film is appropriately set according to the condition settings of the plasma processing device that is used. For example, when an atmospheric pressure plasma polymerization device manufactured by Plasmatreat (Plasma Laboratory Systems, Model PAD-1) is used as the plasma processing device, the nozzle distance is 5 mm to 30 mm, and preferably 7 mm to 25 mm, and the nozzle movement speed is 10 m/min to 40 m/min, and preferably 7 m/min to 35 m/min. When the nozzle distance is less than 5 mm, or when the nozzle movement speed is less than 10 m/min, there is a possibility that the thickness of the coating film will exceed 14 nm. Moreover, when the nozzle distance is greater than 30 mm or the nozzle movement speed is greater than 40 m/min, there is a possibility that the film thickness of the coating film will become less than 4 nm. Here, the nozzle distance is the distance from the tip end of the supply nozzle that sprays the organic silicon compound having a siloxane bond, which is the coating material, to the surface of the metal material on which the coating film is formed. The nozzle movement speed is the speed at which the supply nozzle moves with respect to the metal material.

### 3. LED Device

FIG. 1 illustrates an example of an LED device in which the coating film of the present invention is applied. This LED device 1 is similar to a conventional LED device, and includes a lead frame 2, a reflecting section 3 that is obtained by processing the pedestal of the lead frame 2, and an LED chip 4 that is placed in a position that is surrounded by the reflecting section 3. Particularly, in the present invention, the reflecting section 3 of the LED device 1 includes a metal film 5, and a coating film 6 that is formed on the surface of the metal film 5, where the coating film of the present invention described above is used as the coating film 6.

This kind of LED device 1 has excellent oxidation resistance and corrosion resistance, so even when used in an environment that includes sulfur, or used in a high-temperature environment, there is hardly any discoloration of the reflecting section 3. Therefore, it is possible to suitably use this LED device 1 as a new lighting source or for lighting equipment instead of a conventional incandescent light or fluorescent light.

### [Examples]

The present invention will be explained in more detail using examples. Evaluation of the silver-plated copper substrates (hereafter, called "samples") of Examples 1 to 25 and Comparative Examples 1 to 9 was performed using the evaluation methods (a) to (c) below.

### (a) Sulfur Resistance

The sulfur resistance was evaluated by visually observing with the naked eye the external appearance of the samples of Examples 1 to 25 and Comparative Examples 1 to 9 at each stage below.

First, the external appearance in the initial state of each sample was observed using the naked eye. Next, heat treatment was performed on each sample at 175°C for 1.5 hours, after which a sulfuration test was performed in which the samples were allowed to sit for 30 minutes in ammonium sulfate steam, and the external appearance was observed with the naked eye before and after this sulfuration test. Furthermore, heat treatment was performed on each sample at 175°C for 1.5 hours using a hot air circulation-type dryer, after which the external appearance was observed with the naked eye before and after this heat treatment. Finally, a sulfuration test was performed again, and the external appearance was observed with the naked eye before and after this sulfuration test.

The results of the observations of the external appearance above were evaluated as being: "Excellent (A)" when there was no discoloration of the surface of the samples, and there was no bad external appearance such as processing irregularities or stains due to surface treatment; "Good (B)" when there was light yellowish discoloring of the surface of the samples due to minor sulfuration, or there was a bad external appearance such as processing irregularities or stains due to surface treatment; "Satisfactory (C)" when there was light bluish discoloring of the surface of the samples due to sulfuration; and "Unsatisfactory (F)" when there was heavy bluish black discoloring of the surface of the samples due to the advancement of sulfuration.

### (b) Wire Bonding Characteristic

The wire bonding characteristic was evaluated for the samples of Examples 1 to 25 and Comparative Examples 1 to 9 by bonding a metal wire (1 mil Au wire) using a wire bonder (UTC-1000, manufactured by Shinkawa Ltd.) (second bonding section), after which the metal wire was clamped and sheared by 90° pulling using a wire bonding tester (Dage 5000, manufactured by Dage Japan Co., Ltd.), and the external appearance of the position of shearing of the 2nd bonding section of the wire was observed. Here, the 2nd bonding section of the wire means, for example, the bonding position on the bonding substrate (lead frame or the like) when the capillary moves after the 1st bonding (ball bonding) to the LED chip.

The wire bonding characteristic is evaluated as bering: "Good (A)" when the bond is strong and the wire itself sheared; and "Unsatisfactory (F)" when there was pealing at the bonded surface between the wire and sample.

### (c) Brightness (Luminosity)

The brightness was evaluated by measuring the brightness L value in the initial state of the samples of Examples 1 to 25 and Comparative Examples 1 to 9 and the brightness L value after heat treatment was performed on each sample at 175°C for 1.5 hours using a portable spectrum colorimeter (Color-guide, manufactured by Murakami Color Research Laboratory Co., Ltd.), and then comparing these measured value with each other.

### (Examples 1 to 21, Comparative Examples 1 to 7)

In Examples 1 to 21 and Comparative Examples 1 to 7, samples that were obtained by forming a coating film by the atmospheric pressure plasma polymerization process of the present invention on a base material that was obtained by plating a pure copper substrate with 4 µm thick silver plating (brightness L value: 70) by an electroplating method were used. The conditions for the atmospheric pressure plasma polymerization process of the present invention were as given below.

### (Atmospheric Pressure Plasma Polymerization Process Conditions)

Plasma generator output frequency: 21 kHz
Generator output voltage: 280 V
Pressure: Atmospheric pressure (1013.25 hPa)
Hexamethyldisiloxane introduction amount: 20 g/h
Carrier gas and plasma gas: Nitrogen (Amount of nitrogen included: 100%)

Moreover, in Examples 1 to 21 and Comparative Examples 1 to 7, the nozzle distance and nozzle movement speed when forming the coating film were as given in Table 1.

As a result of performing analysis of the coating films that were formed on the surface of the samples of Examples 1 to 21 and Comparative Examples 1 to 7 using an infrared spectral analyzer (Frontier, manufactured by PerkinElmer Co., Ltd.), it was confirmed that these coating films all included dimethylpolysiloxane that is expressed by the structural formula:

(CH₃)₃SiO - [(CH₃)₂SiO]ₙ - Si(CH₃)₃.

### (Comparative Examples 8, 9)

In Comparative Example 8, samples that were obtained by only plating a pure copper substrate with 4 µm thick silver plating by an electroplating method, in other words, samples of which a coating film was not formed on the silver plating, were used as the samples.

Moreover, in Comparative Example 9, samples that were obtained by plating a pure copper substrate with 4 µm thick silver plating by an electroplating method, and then performing a process similar to the process disclosed in JP2011202239 (A) were used as the samples. More specifically, samples that were obtained by performing a process of adding phosphoric acid as a pH regulator to a processing liquid having the composition given below to adjust the pH to 5.5, immersing the base material in the liquid at 25°C for about 1 minute, then washing the substrate in water and evaporating the water by drying the substrate at 100°C for about 1 minute were used as the samples.

### (Composition of the Processing Liquid)

Inhibitor (triazine-2, 4, 6-trithiol): 0.1 g/L
Potassium iodide: 0.1 g/L
Surfactant (oleyl alcohol ethoxylate): 0.1 g/L
Dissolving auxiliary agent (butyl propylene glycol): 10 g/L
pH buffer (dibasic sodium phosphate): 10 g/L

As a result of performing analysis of the coating film that was formed on the surface of the samples for Comparative Example 9 using an infrared spectral analyzer, it was confirmed that the coating film was a triazine-2, 4, 6-trithiol multilayer film.

**[Table 1]**

| | Coating material | Nozzle distance (mm) | Nozzle movement speed (m/min) | Coating film | Film thickness (nm) |
|---|---|---|---|---|---|
| Ex.1 | HMDSO | 5 | 40 | Dimethylpolysiloxane | 14 |
| Ex.2 | HMDSO | 10 | 20 | Dimethylpolysiloxane | 14 |
| Ex.3 | HMDSO | 10 | 30 | Dimethylpolysiloxane | 13 |
| Ex.4 | HMDSO | 10 | 40 | Dimethylpolysiloxane | 12 |
| Ex.5 | HMDSO | 12 | 10 | Dimethylpolysiloxane | 14 |
| Ex.6 | HMDSO | 12 | 20 | Dimethylpolysiloxane | 13 |
| Ex.7 | HMDSO | 12 | 30 | Dimethylpolysiloxane | 12 |
| Ex.8 | HMDSO | 12 | 40 | Dimethylpolysiloxane | 11 |
| Ex.9 | HMDSO | 15 | 10 | Dimethylpolysiloxane | 10 |
| Ex.10 | HMDSO | 15 | 20 | Dimethylpolysiloxane | 9 |
| Ex.11 | HMDSO | 15 | 30 | Dimethylpolysiloxane | 8 |
| Ex.12 | HMDSO | 15 | 40 | Dimethylpolysiloxane | 8 |
| Ex.13 | HMDSO | 20 | 10 | Dimethylpolysiloxane | 8 |
| Ex.14 | HMDSO | 20 | 20 | Dimethylpolysiloxane | 7 |
| Ex.15 | HMDSO | 20 | 30 | Dimethylpolysiloxane | 6 |
| Ex.16 | HMDSO | 20 | 40 | Dimethylpolysiloxane | 5 |
| Ex.17 | HMDSO | 25 | 10 | Dimethylpolysiloxane | 6 |
| Ex.18 | HMDSO | 25 | 20 | Dimethylpolysiloxane | 5 |
| Ex.19 | HMDSO | 25 | 30 | Dimethylpolysiloxane | 4 |
| Ex.20 | HMDSO | 30 | 10 | Dimethylpolysiloxane | 5 |
| Ex.21 | HMDSO | 30 | 20 | Dimethylpolysiloxane | 4 |
| CE.1 | HMDSO | 5 | 10 | Dimethylpolysiloxane | 17 |
| CE.2 | HMDSO | 5 | 20 | Dimethylpolysiloxane | 16 |
| CE.3 | HMDSO | 5 | 30 | Dimethylpolysiloxane | 15 |
| CE.4 | HMDSO | 10 | 10 | Dimethylpolysiloxane | 15 |
| CE.5 | HMDSO | 25 | 40 | Dimethylpolysiloxane | 3 |
| CE.6 | HMDSO | 30 | 30 | Dimethylpolysiloxane | 3 |
| CE.7 | HMDSO | 30 | 40 | Dimethylpolysiloxane | 2 |
| CE.8 | -- | -- | -- | -- | -- |
| CE.9 | Inhibitor and the like | -- | -- | Triazine-2, 4, 6-trithiol coating film | -- |

| | | | | | |
|---|---|---|---|---|---|
| * Ex: Example; CE: Comparative Example | | | | | |

**[Table 2]**

| | Sulfuration resistance | | | | Wire bonding characteristic | Brightness L value |
|---|---|---|---|---|---|---|
| | Initial | After sulfuration test (first time) | Heat treatment | After sulfuration test (second time) | | |
| Ex.1 | A | A | A | A | A | 91→89 |
| Ex.2 | A | A | A | A | A | 91→89 |
| Ex.3 | A | A | A | A | A | 90→88 |
| Ex.4 | A | A | A | A | A | 89→87 |
| Ex.5 | A | A | A | A | A | 90→88 |
| Ex.6 | A | A | A | A | A | 89→87 |
| Ex.7 | A | A | A | A | A | 89→87 |
| Ex.8 | A | A | A | A | A | 88→86 |
| Ex.9 | A | A | A | A | A | 88→86 |
| Ex.10 | A | A | A | A | A | 87→85 |
| Ex.11 | A | A | A | A | A | 87→84 |
| Ex.12 | A | A | A | A | A | 87→85 |
| Ex.13 | A | A | A | A | A | 87→85 |
| Ex.14 | A | A | A | A | A | 86→83 |
| Ex.15 | A | A | A | A | A | 86→83 |
| Ex.16 | A | A | A | A | A | 85→80 |
| Ex.17 | A | A | A | A | A | 86→81 |
| Ex.18 | A | A | A | A | A | 85→80 |
| Ex.19 | A | A | A | A | A | 84→81 |
| Ex.20 | A | A | A | A | A | 85→82 |
| Ex.21 | A | A | A | A | A | 84→81 |
| CE.1 | B | B | B | B | F | 91→87 |
| CE.2 | B | B | B | B | F | 91→88 |
| CE.3 | B | B | B | B | F | 92→88 |
| CE.4 | B | B | B | B | F | 92→89 |
| CE.5 | A | B | A | F | A | 91→87 |
| CE.6 | A | B | A | F | A | 80→75 |
| CE.7 | A | F | B | F | A | 80→36 |
| CE.8 | A | F | F | F | A | 75→29 |
| CE.9 | B | B | B | B | F | 70→42 |

| | | | | | | |
|---|---|---|---|---|---|---|
| * Ex: Example; CE: Comparative Example | | | | | | |

### (Examples 22, 23)

In Example 22, except for using decamethyltetrasiloxane (DMTSO) as the material of the coating film, the samples were obtained in the same way as in Example 1. Moreover, in Example 23, except for using octamethylcyclotetrasiloxane (OMCTSO) as the material of the coating film, the samples were obtained in the same way as in Example 1.

As a result of performing analysis of the coating film that was formed on the surface of these samples using an infrared spectral analyzer, it was confirmed that these coating films all included dimethylpolysiloxane that is expressed by the structural formula: (CH₃)₃SiO - [(CH₃)₂SiO]ₙ - Si(CH₃)₃. Moreover, as a result of performing evaluations (a) to (c) above on these samples, it was confirmed that these samples have the same characteristics as Examples 1 to 21.

### (Example 24)

Except for using a material in which part of the side chain of hexamethyldisiloxane (HMDSO) was replaced with a phenyl group as the material of the coating film, the samples were obtained in the same way as in Example 1.

As a result of performing analysis of the coating film that was formed on the surface of these samples using an infrared spectral analyzer, it was confirmed that these coating films all included methylphenylpolysiloxane that is expressed by the structural formula: (CH₃)₃SiO - [(CH₃)₂SiO]ₘ - [(C₆H₅]₂SiO]ₙ - Si(CH₃)₃. Moreover, as a result of performing evaluations (a) to (c) above on these samples, it was confirmed that these samples have the same characteristics as Examples 1 to 21.

### (Example 25)

Except for using a material in which part of the side chain of hexamethyldisiloxane (HMDSO) was replaced with a carboxyl group as the material of the coating film, the samples were obtained in the same way as in Example 1.

As a result of performing analysis of the coating film that was formed on the surface of these samples using an infrared spectral analyzer, it was confirmed that these coating films all included carboxyl modified dimethylpolysiloxane that is expressed by the structural formulas (CH₃)₃SiO - [(CH₃)₂SiO]ₘ - [(COOH)₂SiO]ₙ - Si(CH₃)₃. Moreover, as a result of performing evaluations (a) to (c) above on these samples, it was confirmed that these samples have the same characteristics as Examples 1 to 21.

**[Table 3]**

| | Coating material | Nozzle distance (mm) | Nozzle movement speed (m/min) | Coating film | Film thickness (nm) |
|---|---|---|---|---|---|
| Ex.22 | DMTSO | 5 | 40 | Dimethylpolysiloxane | 14 |
| Ex.23 | OMCTSO | 5 | 40 | Dimethylpolysiloxane | 14 |
| Ex.24 | HMDSO + Phenyl group | 5 | 40 | Methylphenyl polysiloxane | 14 |
| Ex.22 | HMDSO + Carboxyl group | 5 | 40 | Carboxyl modified dimethylpolysiloxane | 14 |

| | | | | | |
|---|---|---|---|---|---|
| * Ex: Example | | | | | |

**[Table 4]**

| | Sulfuration resistance | | | | Wire bonding characteristic Initial | Brightness L value |
|---|---|---|---|---|---|---|
| | Initial | After sulfuration test (first time) | Heat treatment | After sulfuration test (second time) | | |
| Ex.22 | A | A | A | A | A | 90→89 |
| Ex.23 | A | A | A | A | A | 91→89 |
| Ex.24 | A | A | A | A | A | 90→89 |
| Ex.22 | A | A | A | A | A | 90→88 |

| | | | | | | |
|---|---|---|---|---|---|---|
| * Ex: Example | | | | | | |

### (Evaluation)

From Examples 1 to 21, it is understood that when the coating film of the present invention (polysiloxane film) was formed, discoloration is not seen in the range where the film thickness was 4 nm to 14 nm, and the sulfur resistance and bonding characteristics are good. Furthermore, when the coating film of the present invention was formed, it is understood that it is possible to improve the brightness L value more than when using only a metal film (silver plating), and it is possible to maintain the brightness L value at a high value even after heat treatment.

Moreover, from Examples 22 and 23, it is understood that even when using an organic silicon compound other than dimethylpolysiloxane as the coating material, it is possible to form a coating film that includes dimethylpolysiloxane as in Examples 1 to 21.

Furthermore, from Examples 24 and 25, it is understood that even when part of the side chain of dimethylpolysiloxane is replaced with a phenyl group or organic group, it is possible to form a coating film that is equivalent to Examples 1 to 21.

On the other hand, Comparative Examples 1 to 7 are examples in which the film thickness of the coating film is outside the range of the present invention. Comparative Examples 1 to 4 differ from the coating film according to the technology disclosed in JP2004510571 (A), and even though the films are thin, the film thickness of the coating film exceeds 14 nm. In Comparative Examples 1 to 4, even though there was no bad external appearance such as processing irregularities or stains due to surface treatment, and the brightness L value was good when compared with the case in which it is presumed to be possible to apply the technology disclosed in JP2004510571 (A) to the formation of a thin coating film, there was light yellowish discoloration of the sample surfaces, and the wire bonding characteristic was also inferior. On the other hand, Comparative Examples 5 to 7 are examples in which the film thickness of the coating film is less than 2 nm. In Comparative Examples 5 to 7, the wire bonding characteristic is sufficient, however, the sulfur resistance is inferior.

Comparative Example 8 is an example in which no coating film is formed, and when compared with the other Examples and Comparative Examples, the sulfur resistance and brightness L value are remarkably inferior.

Comparative Example 9 is an example in which a coating film is formed by a conventional wet method. Therefore, in Comparative Example 9, even though the sulfur resistance is good, the wire bonding characteristic and brightness L value are inferior.

### [Explanation of Reference Numbers]

- 1: Light-emitting diode (LED) device
- 2: Lead frame
- 3: Reflecting section
- 4: LED chip
- 5: Metal film
- 6: Coating film

## Claims

1. A coating film formed on a surface of a metal material comprising:
a poly siloxane film having a thickness of 4 nm to 14 nm,
the polysiloxane film being formed by mixing and spraying an organic silicon compound having a siloxane bond together with a carrier gas that includes at least nitrogen at atmospheric pressure in a nitrogen plasma gas, and performing polymerization by radicalizing the organic silicon compound.

2. The coating film according to Claim 1 wherein the polysiloxane film comprises a polysiloxane having a principal chain of -(Si-O-Si)ₙ-.

3. The coating film according to Claim 2 wherein the polysiloxane is dimethylpolysiloxane.

4. A light-emitting diode device comprising:
a lead frame;
a reflecting section obtained by processing a pedestal of the lead frame; and
an LED chip placed in a position that is surrounded by the reflecting section; and
the reflecting section comprising a metal film and a coating film that is formed on a surface of the metal film, the coating film comprising the coating film according to Claim 1.

5. The light-emitting diode according to Claim 4, wherein the metal film is a silver film or a silver alloy film.

6. The light-emitting diode according to Claim 5, wherein the brightness L value of the reflecting section is 80 or more.

7. A method for forming a coating film comprising steps of:
mixing and spraying an organic silicon compound having a siloxane bond together with a carrier gas that includes at least nitrogen at atmospheric pressure in a nitrogen plasma gas;
performing polymerization by radicalizing the organic silicon compound; and
forming a poly siloxane film having a thickness of 4 nm to 14 nm on a surface of a metal material.

8. The method for forming the coating film according to Claim 7, wherein the organic silicon compound is at least one kind selected from hexamethyldisiloxane (HMDSO), octamethyltrisiloxane (OMTSO), decamethyltetrasiloxane (DMTSO), and octamethylcyclotetrasiloxane (OMCTSO).

9. The method for forming the coating film according to Claim 7, wherein formation of the coating film is performed using an atmospheric pressure plasma polymerization device, with a distance from a supply nozzle of the device to the surface of the metal material being 5 mm to 30 mm, and a movement speed of the supply nozzle being 10 m/min to 40 m/min.

10. The method for forming the coating film according to Claim 7, wherein the polysiloxane film comprises a polysiloxane having a principal chain of -(Si-O-Si)ₙ-.

11. The method for forming the coating film according to Claim 10, wherein the polysiloxane is dimethylpolysiloxane.

12. The method for forming the coating film according to Claim 7, wherein the metal material is silver or a silver alloy.
